(19) Europäisches Patentamt
European Patent Office
Office européen des brevets

(11) **EP 2 506 436 B1**

(12) **EUROPÄISCHE PATENTSCHRIFT**

(45) Veröffentlichungstag und Bekanntmachung des Hinweises auf die Patenterteilung:
**18.04.2018  Patentblatt 2018/16**

(51) Int Cl.:
***H03K 19/0175*** *(2006.01)*

(21) Anmeldenummer: **12002230.6**

(22) Anmeldetag: **28.03.2012**

(54) **Eingangsschaltung für eine Eingangsbaugruppe und Verfahren zum Betreiben einer Eingangsschaltung**

Input circuit for an input component and method for operating same

Circuit d'entrée pour un composant d'entrée et procédé de fonctionnement d'un circuit d'entrée

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.03.2011  DE 102011015498**

(43) Veröffentlichungstag der Anmeldung:
**03.10.2012  Patentblatt 2012/40**

(73) Patentinhaber: **Phoenix Contact GmbH & Co. KG**
**32825 Blomberg (DE)**

(72) Erfinder:
• **Oster, Viktor**
**32825 Blomberg (DE)**

• **Warneke, Thomas**
**37671 Höxter (DE)**
• **Säck, Klaus-Peter**
**32760 Detmold (DE)**

(74) Vertreter: **Bill, Burkart Hartmut**
**Blumbach - Zinngrebe**
**Patent- und Rechtsanwälte PartG mbB**
**Elisabethenstrasse 11**
**64283 Darmstadt (DE)**

(56) Entgegenhaltungen:
**EP-A2- 0 393 282      DE-A1- 19 906 932**
**GB-A- 2 241 126      US-A- 4 788 458**

**Beschreibung**

TECHNISCHES GEBIET

Das technische Gebiet der Erfindung betrifft eine Eingangsschaltung für eine Eingangsbaugruppe zum sicheren Einlesen eines an der Eingangsbaugruppe anliegenden Eingangssignals sowie ein Verfahren zum Betreiben einer solchen Eingangsschaltung.

STAND DER TECHNIK

An einer Eingangsschaltung zum sicheren Einlesen von Signalen oder Eingangssignalen von Befehlsgebern aus der Peripherie werden verschiedenste Anforderungen gestellt. Beispielsweise werden in der DIN EN 61131-2 die Arbeitsbereiche digitaler Eingangsschaltungen beschrieben, um eine Schnittstellenkompatibilität erreichen zu können. Dabei ist der Arbeitsbereich für das Erkennen eines digitalen Null-Zustands für sichere digitale Eingänge von besonderer Bedeutung.

Bei herkömmlichen Eingangsschaltungen wird das Erkennen des Null-Zustands aus der Eingangsspannung abgeleitet, indem die aus der Peripherie anliegende Spannung des Eingangssignals mit einer internen Referenzspannung verglichen wird.

Eine solche sichere Eingangsschaltung mit einkanaligem Peripherieanschluss für den Eingang eines Busteilnehmers ist in der DE 10 2006 030 114 A1 beschrieben.

Die in der DE 10 2006 030 114 A1 beschriebene Eingangsschaltung für eine Eingangsbaugruppe, insbesondere eine Bus-Eingangsbaugruppe, zum sicheren Einlesen von an der Eingangsbaugruppe anliegenden Eingangssignalen, insbesondere gemäß Standards Kat. 4 DIN EN 954 und SIL 3 IEC 61508, hat wenigstens einen Signaleingangsschaltkreis mit einkanaligem Peripherieanschluss zum Anschließen wenigstens eines Signalgebers, einen mit dem Signaleingangsschaltkreis über ein Koppelglied elektrisch anschaltbaren Auswertekreis und einen mit dem Signaleingangsschaltkreis elektrisch verbundenen Vergleichsschaltkreis zum Einstellen einer Referenzspannung zum Aktivieren und Deaktivieren des Koppelglieds.

EP 0 393 282 A2 beschreibt einen Eingangsschaltkreis mit einem Optokoppler, um ein Steuersignal von einem Mikroprozessor galvanisch zu trennen. Der Eingangsschaltkreis weist einen Transistor und eine Zenerdiode auf. Sobald die Zenerspannung der Zenerdiode erreicht ist, steuert die Zenerdiode einen konstanten Strom durch den Transistor. Dies ist aufgrund einer nahezu konstanten Spannung an einem Widerstand möglich, der zwischen einem Emitter des Transistors und einer Diode des Optokopplers verbunden ist.

DE 199 06 932 A1 beschreibt ein Binäreingabegerät 1 mit einem oder mehrerer Binäreingabekanälen, wobei jeder Eingabekanal einen Komparator aufweist. Der Komparator ist für einen Vergleich eines an einen Signaleingang anlegbaren Eingangssignals mit einer an einen Referenzspannungseingang anlegbaren Referenzspannung eingerichtet.

GB 2 241 126 A beschreibt Eingangsschaltkreise zur galvanischen Trennung eines Eingangssignals von einem Ausgangssignal, das einer Steuerung zuführbar ist. Der Eingangsschaltkreis weist einen Gleichrichtungsschaltkreis, einen Konstantstrom-Schaltkreis und einen Trennschaltkreis auf. Der Konstantstrom-Schaltkreis und eine lichtemittierende Diode eines Optokopplers des Trennschaltkreises sind in Reihe am Ausgang des Gleichrichtungsschaltkreises geschaltet. Ferner weist der Konstantstrom-Schaltkreis einen ersten Widerstand, einen zweiten Widerstand, eine Zenerdiode und einen Transistors auf. Hierbei wird der Strom vom Emitter zum Kollektor des Transistors durch eine konstante Spannung am zweiten Widerstand gesteuert und bleibt konstant.

Ferner ist aus der US 4,788,458 eine Zwei-Draht Interface Schaltung bekannt, gemäß welcher ein Koppelglied in Abhängigkeit des über einen Widerstandes fließenden Strom mittels eines npn-Transistors aktiviert oder deaktiviert wird. Die Basis-Emitter-Diode eines weiteren Transistors definiert hierbei eine Referenzspannung.

OFFENBARUNG DER ERFINDUNG

Es ist daher eine Aufgabe der vorliegenden Erfindung eine verbesserte Eingangsschaltung zu schaffen.

Diese Aufgabe wird durch eine Eingangsschaltung mit den Merkmalen des Anspruchs 1 sowie durch ein Verfahren mit den Merkmalen des Anspruchs 13 gelöst.

Demgemäß wird eine Eingangsschaltung für eine Eingangsbaugruppe zum sicheren Einlesen eines an der Eingangsbaugruppe anliegenden Eingangssignals vorgeschlagen. Die Eingangsschaltung weist einen Signaleingangsschaltkreis, ein Koppelglied, einen Auswerteschaltkreis, eine Referenzspannungsschaltung und einen Vergleichsschaltkreis auf. Der Signaleingangsschaltkreis hat einen einkanaligen Peripherieanschluss zum Anschließen zumindest eines Signalgebers, welcher das Eingangssignal bereitstellt. Der Auswerteschaltkreis ist mit dem Signaleingangsschaltkreis über ein Koppelglied koppelbar. Die Referenzspannungsschaltung ist mit dem Signaleingangsschaltkreis elektrisch verbunden und stellt eine Referenzspannung bereit. Der Vergleichsschaltkreis ist zwischen dem Signaleingangsschaltkreis und dem Koppelglied gekoppelt. Der Vergleichsschaltkreis aktiviert und deaktiviert das Koppelglied in Abhängigkeit des Stroms des an dem Signaleingangsschaltkreis anliegenden Eingangssignals und der bereitgestellten Referenzspannung.

Folglich wird eine Eingangsschaltung bereitgestellt, bei der ein sicherer Null-Zustand sowohl über den Strom des Eingangssignals als auch über die Spannung des Eingangssignals detektiert werden kann. Damit ist bei dieser Eingangsschaltung sichergestellt, diese Eigenschaften auch unter definierten Fehlern nicht zu verlieren und somit die Anforderungen an die DIN EN ISO 13849 und DIN EN 61508 zu erfüllen.

Der Vergleichsschaltkreis weist einen npn-Transistor mit einer für den Strom des Eingangssignals bestimmten, einstellbaren Schaltschwelle auf. Ferner weist der Vergleichsschaltkreis einen zwischen der Basis des npn-Transistors und einem ersten Widerstand des Signaleingangsschaltkreises gekoppelten zweiten Widerstand und einen zwischen dem Emitter des npn-Transistors und Masse gekoppelten dritten Widerstand auf, wobei die Schaltschwelle durch $\frac{1}{R_3}(U_{Ref} - U_{BE})$ bestimmt ist, wobei $R_3$ den dritten Widerstand, $U_{Ref}$ die Referenzspannung und $U_{BE}$ die Basis-Emitter-Spannung des npn-Transistors bezeichnen. Dabei aktiviert der Transistor das Koppelglied, falls der Strom des Eingangssignals größer als die Schaltschwelle ist. Der Transistor deaktiviert das Koppelglied, falls der Strom des Eingangssignals kleiner als die Schaltschwelle ist.

Das Auslösen bzw. Erreichen der einstellbaren, für den Strom des Eingangssignals bestimmten Schaltschwelle wird folglich über den Strom des Eingangssignals bestimmt.

Weiterhin wird ein Verfahren zum Betreiben einer Eingangsschaltung für eine Eingangsbaugruppe zum sicheren Einlesen eines an der Eingangsbaugruppe anliegenden Eingangssignals vorgeschlagen, wobei die Eingangsschaltung einen Signaleingangsschaltkreis mit einem einkanaligen Peripherieanschluss zum Anschließen zumindest eines Signalgebers zum Bereitstellen des Eingangssignals und einen mit dem Signaleingangsschaltkreis über ein Koppelglied koppelbaren Auswerteschaltkreis aufweist. Das Verfahren hat einen Schritt eines Bereitstellens einer Referenzspannung. Weiter hat das Verfahren einen Schritt eines Aktivierens und Deaktivierens des Koppelglieds in Abhängigkeit des Stroms des an dem Signaleingangsschaltkreis anliegenden Eingangssignals und der bereitgestellten Referenzspannung.

Vorteilhafte Ausgestaltungen und Weiterbildungen der Erfindung ergeben sich aus den Unteransprüchen sowie der Beschreibung unter Bezugnahme auf die Zeichnungen.

Gemäß einer bevorzugten Weiterbildung ist der Vergleichsschaltkreis dazu eingerichtet, die bereitgestellte Referenzspannung mit einer zu dem Strom des Eingangssignals proportionalen Spannung zum Aktivieren und Deaktivieren des Koppelglieds zu vergleichen.

In Abhängigkeit des Vergleiches kann der Vergleichsschaltkreis das Koppelglied aktivieren oder deaktivieren.

Dabei kann die Eingangsschaltung Mittel aufweisen, welche zur Einstellung der Schaltschwelle geeignet sind. Diese Mittel können als programmierbare Mittel ausgestaltet sein.

Gemäß einer weiteren bevorzugten Weiterbildung stellt der Auswerteschaltkreis ausgangsseitig einen digitalen Null-Zustand für das Eingangssignal bereit, falls der Transistor das Koppelglied deaktiviert.

Falls der Transistor das Koppelglied aktiviert, kann der Auswerteschaltkreis ausgangsseitig einen digitalen Eins-Zustand für das Eingangssignal bereitstellen.

Gemäß einer weiteren bevorzugten Weiterbildung ist der Strom durch die Eingangsschaltung ausschließlich durch das an dem Signaleingangsschaltkreis anliegende Eingangssignal treibbar.

Damit ist durch die Struktur der Eingangsschaltung sichergestellt, dass der Strom durch die Eingangsschaltung lediglich durch das an dem Signaleingangsschaltkreis anliegende Eingangssignal betrieben werden kann.

Auch der Einsatz einer anderen Transistortechnologie, beispielsweise der Einsatz eines pnp-Transistors, ist möglich.

Gemäß einer weiteren bevorzugten Weiterbildung ist die Referenzspannungsschaltung dazu eingerichtet, die Schaltschwelle durch ein Einstellen der Referenzspannung einzustellen.

Die Spannung zur Einstellung der Schaltschwelle zum sicheren Erkennen des Null-Zustands am Eingang der Eingangsschaltung wird über die Referenz oder Referenzspannungsschaltung eingestellt. Erst, wenn eine Spannung $V_2$ an dem Emitter des npn-Transistors größer gleich einer Spannung von $U_{Ref} - U_{BE}$ ist, sperrt der Transistor und es kann ein Strom durch den Eingang des Koppelglieds fließen. Die Spannung $V_2$ an dem Emitter ist direkt proportional zum Stromfluss durch den dritten Widerstand $R_3$:

$$V_2 \geq U_{Ref} - U_{BE}$$

(1)

$$V_2 = R_3 \cdot I_L$$

(2)

Aus obigen Gleichungen (1) und (2) leitet sich die Schaltschwelle für einen Eingangsstrom $I_L$, bis zu dem der Null-Zustand von dem Auswerteschaltkreis interpretiert wird:

$$\text{Null-Zustand:}\ \ I_L \leq \frac{U_{Ref} - U_{BE}}{R_3}$$

(3)

$$\text{Eins-Zustand:} \quad I_L > \frac{U_{Ref} - U_{BE}}{R_3}$$

$$(4)$$

Erreicht der Spannungsabfall über dem Widerstand $R_3$ den Wert von $U_{Ref}$ - $U_{BE}$, sperrt der Transistor und der Eingangsstrom $I_L$ kann durch den Eingang des Koppelglieds fließen.

Das Auslösen bzw. Erreichen der einstellbaren, für den Strom des Eingangssignals bestimmten Schaltschwelle wird folglich wiederum über den Strom des Eingangssignals bestimmt.

Gemäß einer weiteren bevorzugten Weiterbildung weist die Referenzspannungsschaltung eine Zenerdiode auf.

Gemäß einer weiteren bevorzugten Weiterbildung ist das Koppelglied ein Optokoppler.

Gemäß einer weiteren bevorzugten Weiterbildung ist eine mit dem Signaleingangsschaltkreis elektrisch verbundene erste Testschaltung zum Testen der Vergleichsschaltung und des Koppelglieds vorgesehen.

Durch die Verwendung der ersten Testschaltung wird es möglich, die Funktion des Vergleichsschaltkreises und die Funktion des Koppelglieds zu prüfen, um eventuelle Bauteilausfälle diagnostizieren zu können. Der Test wird insbesondere als ein dynamischer Test ausgeführt.

Gemäß einer weiteren bevorzugten Weiterbildung ist eine Begrenzungseinheit zur Begrenzung des Stroms des Eingangssignals zwischen dem Signaleingangsschaltkreis und dem Vergleichsschaltkreis angeordnet.

Die Begrenzungseinheit ist beispielsweise eine Strombegrenzungseinheit, welche eine Zenerdiode aufweist. Die Strombegrenzungseinheit ist insbesondere dazu eingerichtet, die Verlustleistung der Eingangsschaltung zu reduzieren. Beispielsweise kann durch die Begrenzungseinheit der Eingangsstrom der Eingangsschaltung ab einer durch die Zenerdiode einstellbaren Spannung begrenzt werden, was zur Reduzierung der Verlustleistung führen kann. Hierdurch wird es ermöglicht, die Eingangsschaltung auch in kleinen Gehäusen einzusetzen.

Gemäß einer weiteren bevorzugten Weiterbildung ist eine mit der Referenzspannungsschaltung elektrisch verbundene zweite Testschaltung zum Testen der von der Referenzspannungsschaltung bereitgestellten Referenzspannung vorgesehen.

Der Test durch die zweite Testschaltung oder Testeinheit wird vorzugsweise als ein dynamischer Test ausgeführt.

Insbesondere ist die zweite Testschaltung zur Erhöhung der Eigendiagnose der Eingangsschaltung eingerichtet, um zu ermöglichen, die die Schaltschwellen bestimmende Referenz zu prüfen.

Des Weiteren wird eine Eingangsbaugruppe vorgeschlagen, welche zumindest eine wie oben erläuterte Eingangsschaltung zum sicheren Einlesen eines an der Eingangsbaugruppe anliegenden Eingangssignals aufweist.

Gemäß einer bevorzugten Weiterbildung hat die Eingangsbaugruppe eine Mehrzahl von Eingangsschaltungen, eine einzige Referenzspannungsschaltung zum Bereitstellen einer Referenzspannung und eine einzige zweite Testschaltung zum Testen der Referenzspannungsschaltung.

Somit genügt insbesondere eine einzige Referenzspannungsschaltung für die Bereitstellung von Referenzspannungen für die Mehrzahl der Eingangsschaltungen. Weiter genügt hierbei eine einzige zweite Testschaltung zum Testen der Referenzspannungsschaltung.

Die Erfindung wird nachfolgend anhand der in den schematischen Figuren angegebenen Ausführungsbeispiele näher erläutert. Es zeigen:

Figur 1  ein schematisches Blockschaltbild eines ersten Ausführungsbeispiels einer Eingangsschaltung zum sicheren Einlesen eines anliegenden Eingangssignals;

Figur 2  ein schematisches Blockschaltbild eines zweiten Ausführungsbeispiels einer Eingangsschaltung zum sicheren Einlesen eines anliegenden Eingangssignals;

Figur 3  ein schematisches Blockschaltbild eines dritten Ausführungsbeispiels einer Eingangsschaltung zum sicheren Einlesen eines anliegenden Eingangssignals;

Figur 4  ein schematisches Blockschaltbild eines vierten Ausführungsbeispiels einer Eingangsschaltung zum sicheren Einlesen eines anliegenden Eingangssignals;

Figur 5  ein schematisches Blockschaltbild eines Ausführungsbeispiels einer Eingangsbaugruppe mit zwei Eingangsschaltungen; und

Figur 6  ein schematisches Ablaufdiagramm eines Ausführungsbeispiels eines Verfahrens zum Betreiben einer Eingangsschaltung zum sicheren Einlesen eines anliegenden Eingangssignals.

In allen Figuren sind gleiche bzw. funktionsgleiche Mittel und Einrichtungen - sofern nichts anderes angegeben - mit denselben Bezugszeichen versehen.

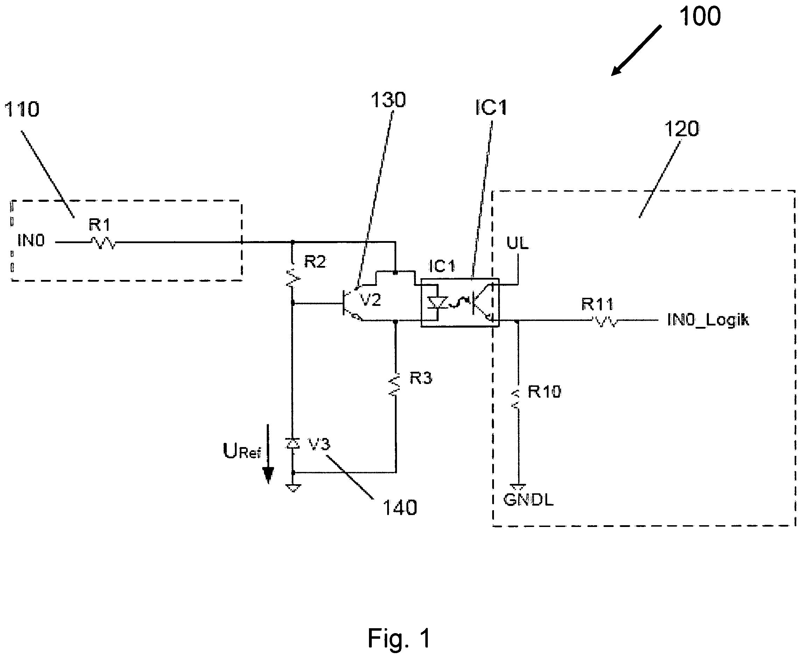

In Figur 1 ist ein schematisches Blockschaltbild eines ersten Ausführungsbeispiels einer Eingangsschaltung 100 zum Einlesen eines anliegenden Eingangssignals dargestellt.

Die Eingangsschaltung 100 hat einen Signaleingangsschaltkreis 110, einen Auswerteschaltkreis 120, einen Vergleichsschaltkreis 130, eine Referenzspannungsschaltung 140 und ein Koppelglied IC1.

Der Signaleingangsschaltkreis 110 hat einen einkanaligen Peripherieanschluss zum Anschließen zumindest eines Signalgebers zum Bereitstellen des Eingangssignals INO. Dabei weist der Signaleingangsschaltkreis 110 einen ersten Widerstand $R_1$ auf.

Das Koppelglied IC1 koppelt den Signaleingangsschaltkreis 110 mit dem Auswerteschaltkreis 120. Das Koppelglied IC1 ist beispielsweise als ein Opto-Koppler ausgebildet.

Mit dem Signaleingangsschaltkreis 110 ist die Referenzspannungsschaltung 140 zum Bereitstellen einer Referenzspannung $U_{Ref}$ elektrisch verbunden. Die Referenzspannungsschaltung 140 ist beispielsweise durch eine Zenerdiode ausgebildet.

Der Vergleichsschaltkreis 130 ist zwischen dem Signaleingangsschaltkreis 110 und dem Koppelglied IC1 gekoppelt. Der Vergleichsschaltkreis 130 kann das Koppelglied IC1 in Abhängigkeit des Stroms des an dem Signaleingangsschaltkreis 110 anliegenden Eingangssignals INO und der bereitgestellten Referenzspannung $U_{Ref}$ aktivieren und deaktivieren. Dabei vergleicht der Vergleichsschaltkreis 130 die Referenzspannung $U_{Ref}$ mit einer zu dem Strom des Eingangssignals INO proportionalen Spannung, um die Entscheidung hinsichtlich des Aktivierens oder Deaktivierens des Koppelglieds IC1 zu treffen.

Der Vergleichsschaltkreis 130 hat insbesondere einen npn-Transistor mit einer für den Strom des Eingangssignals INO bestimmten, einstellbaren Schaltschwelle. Das Auslösen bzw. Erreichen der einstellbaren Schaltschwelle wird über den Strom des Eingangssignals bestimmt. Der npn-Transistor 130 aktiviert das Koppelglied IC1, wenn der Strom des Eingangssignals INO größer als die Schaltschwelle ist. Dahingegen deaktiviert der npn-Transistor 130 das Koppelglied IC1, wenn der Strom des Eingangssignals INO kleiner als die Schaltschwelle ist. Die Schaltschwelle ist bestimmt durch

$$\frac{1}{R_3}(U_{Ref} - U_{BE}) ,$$

wobei $R_3$ den dritten Widerstand, $U_{Ref}$ die Referenzspannung und $U_{BE}$ die Basis-Emitter-Spannung des npn-Transistors 130 bezeichnen.

Des Weiteren ist die Struktur der Eingangsschaltung 100 gemäß Figur 1 derart ausgestaltet, dass der Strom durch die Eingangsschaltung 100 lediglich durch das Eingangssignal INO getrieben werden kann.

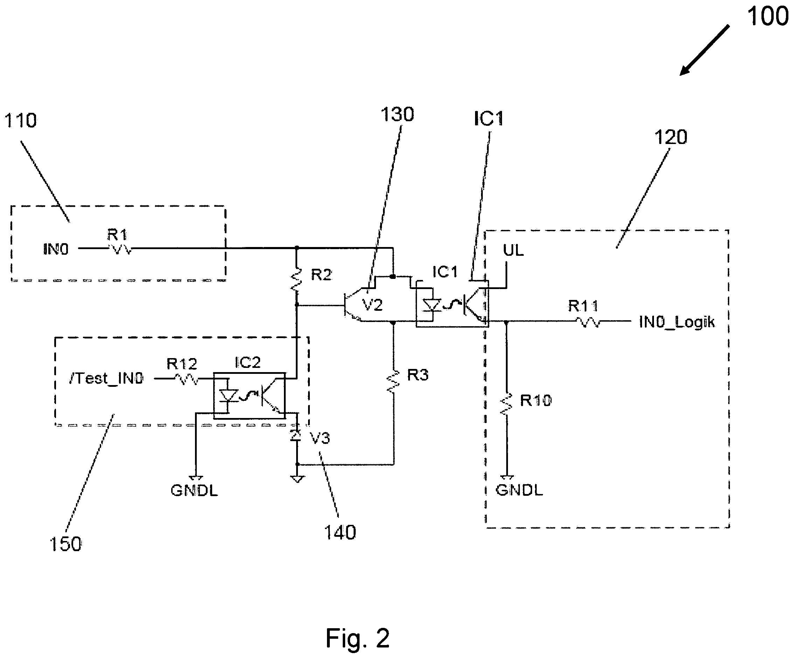

Die Figur 2 zeigt ein schematisches Blockschaltbild eines zweiten Ausführungsbeispiels einer Eingangsschaltung 100 zum sicheren Einlesen eines anliegenden Eingangssignals INO.

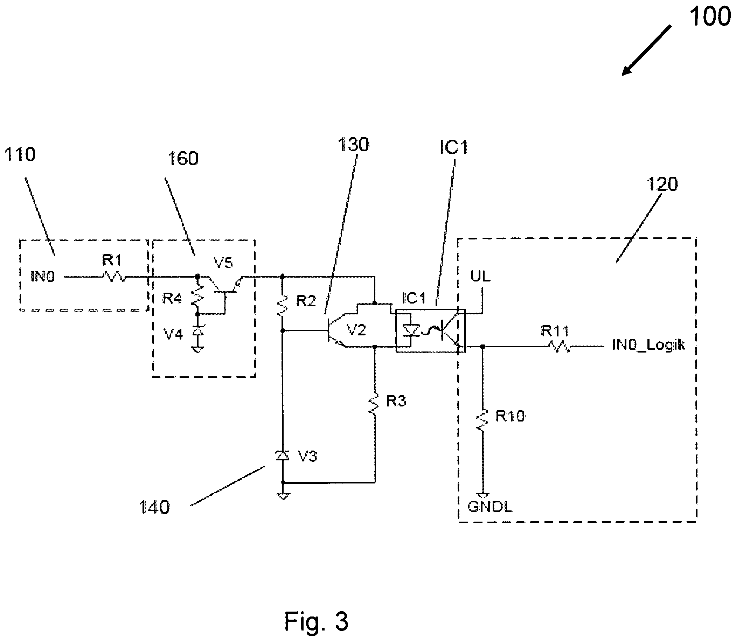

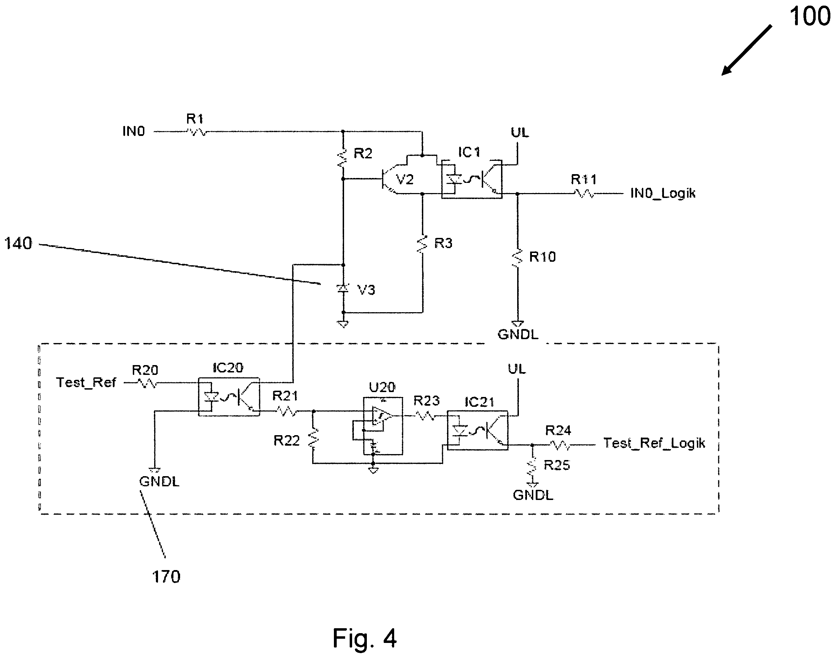

Das zweite Ausführungsbeispiel der Figur 2 sowie die weiteren Ausführungsbeispiele der Figuren 3 und 4 basieren auf dem ersten Ausführungsbeispiel der Figur 1 und weisen alle Merkmale des ersten Ausführungsbeispiels auf. Zur Vermeidung von Wiederholungen werden die Übereinstimmungsmerkmale mit Bezug auf die Figuren 2, 3 und 4 nicht erneut erläutert.

Die Eingangsschaltung 100 der Figur 2 weist gegenüber der Eingangsschaltung 100 der Figur 1 zusätzlich eine erste Testschaltung 150 zum Testen der Vergleichsschaltkreis 130 und des Koppelglieds IC1 auf. Die erste Testschaltung 150 ist mit dem Signaleingangsschaltkreis 110 elektrisch verbunden. Die erste Testschaltung 150 weist ein zweites Koppelglied IC2 sowie einen Widerstand $R_{12}$ auf.

Insbesondere ist die erste Testschaltung 150 dazu eingerichtet, eventuelle Bauteilausfälle des Vergleichsschaltkreises 130 und des Koppelglieds IC1 zu prüfen.

Dazu wird das Signal /Test_INO, welches im normalen Betriebsfall gesetzt ist, kurzzeitig abgeschaltet. Dies führt dazu, dass der Transistor 130 den Stromfluss übernimmt. Dadurch kann kein Strom durch das Koppelglied IC1 mehr getrieben werden. Die erzwungene testweise Änderung des Signals INO_Logik am Ausgang der Auswerteschaltkreis 120 kann von einer nachgeschalteten Logikeinheit ausgewertet werden.

In der Figur 3 ist ein schematisches Blockschaltbild eines dritten Ausführungsbeispiels einer Eingangsschaltung 100 zum sicheren Einlesen eines anliegenden Eingangssignals INO abgebildet. Das dritte Ausführungsbeispiel der Eingangsschaltung 100 gemäß Figur 3 hat zusätzlich zu dem ersten Ausführungsbeispiel der Figur 1 eine Begrenzungseinheit 160 zur Begrenzung des Stroms des Eingangssignals INO. Die Begrenzungseinheit 160 ist zwischen dem Signaleingangsschaltkreis 110 und dem Vergleichsschaltkreis 130 gekoppelt. Durch die Begrenzungseinheit 160 oder Strombegrenzungseinheit wird der Eingangsstrom der Eingangsschaltung 100 ab einer durch die Zenerdiode V4 der Begrenzungseinheit 160 einstellbaren Spannung begrenzt. Dies führt zur Reduzierung der Verlustleistung.

In Figur 4 ist ein schematisches Blockschaltbild eines vierten Ausführungsbeispiels einer Eingangsschaltung 100 zum sicheren Einlesen eines anliegenden Eingangssignals dargestellt. Das vierte Ausführungsbeispiel der Eingangsschaltung 100 ist gegenüber dem ersten Ausführungsbeispiel der Figur 1 dahingehend erweitert, dass eine zweite Testschaltung 170 vorgesehen ist. Die zweite Testschaltung 170 ist mit dem Referenzspannungsschaltkreis 140 elektrisch verbunden und zum Testen der von der Referenzspannungsschaltung 140 bereitgestellten Referenzspannung $U_{Ref}$ eingerichtet. Mit der zweiten Testschaltung 170 ist es möglich, die schaltschwellenbestimmende Referenz zu prüfen. Dazu wird aus einer vorgestalteten Logikeinheit das Signal Test_Ref gesetzt, wodurch die Spannung der Referenzspannungsschaltung 140 auf einen Komparator der zweiten Testschaltung 170 geschaltet wird, in welchem diese mit einer weiteren Referenzspannung verglichen wird. Das Ergebnis dieses Vergleichs wird über ein weiteres Koppelglied IC21 der Logikeinheit übermittelt und von dieser ausgewertet. Das weitere Koppelglied IC21 kann als Opto-Koppler ausgebildet sein.

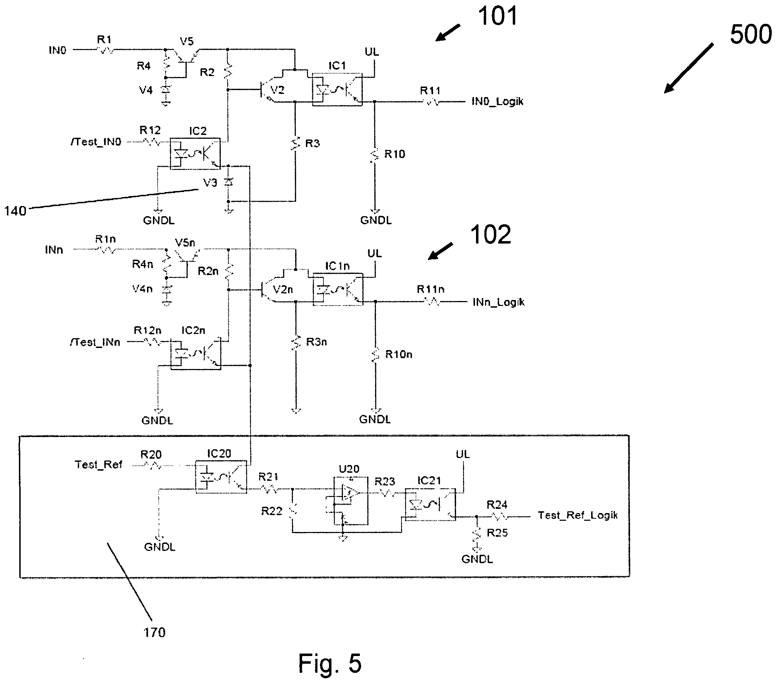

In der Figur 5 ist ein schematisches Blockschaltbild einer Eingangsbaugruppe 500 mit zwei Eingangsschaltungen 101, 102 dargestellt. Gemäß der Ausgestaltung der Figur 5 hat die Eingangsbaugruppe 500 eine erste Eingangsschaltung 101 und eine zweite Eingangsschaltung 102. Die Eingangsbaugruppe kann auch mehr als zwei Eingangsschaltungen haben.

Die erste Eingangsschaltung 101 und die zweite Eingangsschaltung 102 sind mit einer einzigen Referenzspannungsschaltung 140 gekoppelt. Diese einzige Referenzspannungsschaltung stellt eine Referenzspannung für die erste Eingangsschaltung 101 und für die zweite Eingangsschaltung 102 bereit. Zum Testen der einen Referenzspannungsschaltung 140 ist eine einzige zweite Testschaltung 170 vorgesehen.

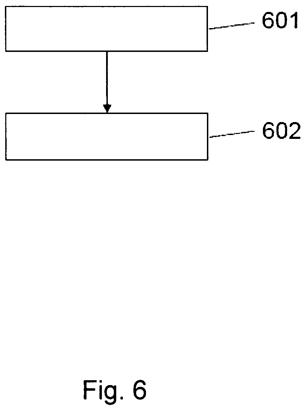

In Figur 6 ist ein schematisches Ablaufdiagramm eines Ausführungsbeispiels eines Verfahrens zum Betreiben einer Eingangsschaltung zum sicheren Einlesen eines anliegenden Eingangssignals dargestellt. Beispiele für eine solche Eingangsschaltung sind in den Fig. 1 bis 4 dargestellt.

Insbesondere hat die Eingangsschaltung einen Signaleingangsschaltkreis mit einem einkanaligen Peripherieanschluss zum Anschließen zumindest eines Signalgebers zum Bereitstellen des Eingangssignals und einen mit dem Signaleingangsschaltkreis über ein Koppelglied koppelbaren Auswerteschaltkreis.

In Schritt 601 wird eine Referenzspannung bereitgestellt.

In Schritt 602 wird das Koppelglied in Abhängigkeit des Stroms des an dem Signaleingangsschaltkreis anliegenden Eingangssignals und der bereitgestellten Referenzspannung aktiviert oder deaktiviert.

Obwohl die vorliegende Erfindung vorstehend anhand der bevorzugten Ausführungsbeispiele beschrieben wurde, ist sie darauf nicht beschränkt, sondern auf vielfältige Art und Weise modifizierbar.

Insbesondere können die Ausführungsbeispiele der Figuren 2, 3 und 4 zur Bildung zumindest eines weiteren Ausführungsbeispiels beliebig kombiniert werden.

BEZUGSZEICHENLISTE

100 Eingangsschaltung
101 Eingangsschaltung
102 Eingangsschaltung
110 Signaleingangsschaltkreis
120 Auswerteschaltkreis
130 Vergleichsschaltkreis
140 Referenzspannungsschaltung
150 erste Testschaltung
160 Begrenzungseinheit
170 zweite Testschaltung

500 Eingangsbaugruppe
601 Verfahrensschritt
602 Verfahrensschritt
IC1 Koppelglied
IC2 Koppelglied
IC20 Koppelglied
IC21 Koppelglied
INO Eingangssignal
INO_Logik Ausgangssignal
R1 Widerstand
R2 Widerstand
R3 Widerstand
R4 Widerstand
R10 Widerstand
R12 Widerstand
R20 Widerstand
R21 Widerstand
R22 Widerstand
R23 Widerstand
R24 Widerstand
R25 Widerstand
GNDL Masse
Test_Ref Testsignal zum Testen der Referenzspannung
Test_Ref_Logik Ausgangssignal zum Testen der Referenzspannung
$U_{Ref}$ Referenzspannung

**Patentansprüche**

1. Eingangsschaltung (100) für eine Eingangsbaugruppe zum sicheren Einlesen eines an der Eingangsbaugruppe anliegenden Eingangssignals (INO), mit:

    einem Signaleingangsschaltkreis (110) mit einem einkanaligen Peripherieanschluss zum Anschließen zumindest eines Signalgebers zum Bereitstellen des Eingangssignals (INO),
    einem mit dem Signaleingangsschaltkreis (110) über ein Koppelglied (IC1) koppelbaren Auswerteschaltkreis (120),
    einer mit dem Signaleingangsschaltkreis (110) elektrisch verbundenen Referenzspannungsschaltung (140) zum Bereitstellen einer Referenzspannung ($U_{Ref}$) und
    einem zwischen dem Signaleingangsschaltkreis (110) und dem Koppelglied (IC1) gekoppelten Vergleichsschaltkreis (130) zum Aktivieren und Deaktivieren des Koppelglieds (IC1) in Abhängigkeit des Stroms des an dem Signaleingangsschaltkreis (110) anliegenden Eingangssignals (INO) und der bereitgestellten Referenzspannung ($U_{Ref}$), wobei der Vergleichsschaltkreis (130) einen npn-Transistor mit einer für den Strom des Eingangssignals (INO) bestimmten, einstellbaren Schaltschwelle aufweist, wobei der npn-Transistor das Koppelglied (IC1) aktiviert, falls der Strom des Eingangssignals (INO) größer als die Schaltschwelle ist und der npn-Transistor das Koppelglied (IC1) deaktiviert, falls der Strom des Eingangssignals (INO) kleiner als die Schaltschwelle ist und wobei

der Vergleichsschaltkreis (130) einen zwischen der Basis des npn-Transistors und einem ersten Widerstand ($R_1$) des Signaleingangsschaltkreises (110) gekoppelten zweiten Widerstand ($R_2$) aufweist und, dass der Vergleichsschaltkreis (130) einen zwischen dem Emitter des npn-Transistors und Masse gekoppelten dritten Widerstand ($R_3$) aufweist, so dass die Schaltschwelle gleich

$$\frac{1}{R_3}(U_{Ref} - U_{BE})$$

ist, wobei $R_3$ den dritten Widerstand, $U_{Ref}$ die Referenzspannung und $U_{BE}$ die Basis-Emitter-Spannung des npn-Transistors bezeichnen.

2. Eingangsschaltung (100) nach Anspruch 1,
   **dadurch gekennzeichnet,**
   **dass** der Vergleichsschaltkreis (130) dazu eingerichtet ist, die bereitgestellte Referenzspannung ($U_{Ref}$) mit einer zu dem Strom des Eingangssignals (INO) proportionalen Spannung zum Aktivieren und Deaktivieren des Koppelglieds (IC1) zu vergleichen.

3. Eingangsschaltung (100) nach Anspruch 1 oder 2,
   **dadurch gekennzeichnet,**
   **dass** der Auswerteschaltkreis (120) ausgangsseitig einen digitalen Null-Zustand für das Eingangssignal (INO) bereitstellt, falls der npn-Transistor das Koppelglied (IC1) deaktiviert.

4. Eingangsschaltung (100) nach einem der vorstehenden Ansprüche,
   **dadurch gekennzeichnet,**
   **dass** der Strom durch die Eingangsschaltung (100) ausschließlich durch das an dem Signaleingangsschaltkreis (110) anliegende Eingangssignal (INO) treibbar ist.

5. Eingangsschaltung (100) nach einem der vorstehenden Ansprüche,
   **dadurch gekennzeichnet,**
   **dass** die Referenzspannungsschaltung (140) dazu eingerichtet ist, die Schaltschwelle durch ein Einstellen der Referenzspannung einzustellen.

6. Eingangsschaltung (100) nach einem der vorstehenden Ansprüche,
   **dadurch gekennzeichnet,**
   **dass** die Referenzspannungsschaltung (140) eine Zenerdiode aufweist.

7. Eingangsschaltung (100) nach einem der vorstehenden Ansprüche,
   **dadurch gekennzeichnet,**
   **dass** das Koppelglied (IC1) ein Optokoppler ist.

8. Eingangsschaltung (100) nach einem der vorstehenden Ansprüche,
   **dadurch gekennzeichnet,**
   **dass** eine mit dem Signaleingangsschaltkreis (110) elektrisch verbundene erste Testschaltung (150) zum Testen des Vergleichsschaltkreises (130) und des Koppelglieds (IC1) vorgesehen ist.

9. Eingangsschaltung (100) nach einem der vorstehenden Ansprüche,
   **dadurch gekennzeichnet,**
   **dass** eine Begrenzungseinheit (160) zur Begrenzung des Stroms des Eingangssignals (INO) zwischen dem Signaleingangsschaltkreis (110) und dem Vergleichsschaltkreis (130) angeordnet ist.

10. Eingangsschaltung (100) nach einem der vorstehenden Ansprüche,
    **dadurch gekennzeichnet,**
    **dass** eine mit der Referenzspannungsschaltung (140) elektrisch verbundene zweite Testschaltung (170) zum Testen der von der Referenzspannungsschaltung (140) bereitgestellten Referenzspannung ($U_{Ref}$) vorgesehen ist.

11. Eingangsbaugruppe (500), mit:

    zumindest einer Eingangsschaltung (100, 101, 102) zum sicheren Einlesen eines an der Eingangsbaugruppe anliegenden Eingangssignals nach einem der vorstehenden Ansprüche.

12. Eingangsbaugruppe (500) nach Anspruch 11,
    **dadurch gekennzeichnet,**
    **dass** eine Mehrzahl von Eingangsschaltungen (100, 101, 102) nach einem der Ansprüche 1 bis 11, eine einzige Referenzspannungsschaltung (140) zum Bereitstellen einer Referenzspannung ($U_{Ref}$) und eine einzige zweite Testschaltung (170) zum Testen der Referenzspannungsschaltung (140) vorgesehen sind.

13. Verfahren zum Betreiben einer Eingangsschaltung (100) für eine Eingangsbaugruppe zum sicheren Einlesen eines an der Eingangsbaugruppe anliegenden Eingangssignals (INO), wobei die Eingangsschaltung (100) einen Signaleingangsschaltkreis (110) mit einem einkanaligen Peripherieanschluss zum Anschließen zumindest eines Signalgebers zum Bereitstellen des Eingangssignals (INO) und einen mit dem Signaleingangsschaltkreis (110) über ein Koppelglied (IC1) koppelbaren Auswerteschaltkreis (120) aufweist,

und wobei die Eingangsschaltung (100) einen Vergleichsschaltkreis (130) aufweist, mit einem npn-Transistor mit einer für den Strom des Eingangssignals (INO) bestimmten, einstellbaren Schaltschwelle, mit einem zwischen der Basis des npn-Transistors und einem ersten Widerstand ($R_1$) des Signaleingangsschaltkreises (110) gekoppelten zweiten Widerstand ($R_2$) und mit einem zwischen dem Emitter des npn-Transistors und Masse gekoppelten dritten Widerstand ($R_3$),

mit den Schritten:

Bereitstellen (601) einer Referenzspannung ($U_{Ref}$) in einer Referenzspannungsschaltung (140), die mit dem Signaleingangsschaltkreis (110) elektrisch verbunden ist, und

Aktivieren und Deaktivieren (602) des Koppelglieds (IC1) in Abhängigkeit des Stroms des an dem Signaleingangsschaltkreis (110) anliegenden Eingangssignals (INO) und der bereitgestellten Referenzspannung ($U_{Ref}$), so dass die

$$\frac{1}{R_3}(U_{Ref} - U_{BE})$$

Schaltschwelle gleich

wird und der npn-Transistor das Koppelglied (IC1) aktiviert, falls der Strom des Eingangssignals (INO) größer als die Schaltschwelle ist und der npn-Transistor das Koppelglied (IC1) deaktiviert, falls der Strom des Eingangssignals (INO) kleiner als die Schaltschwelle ist, wobei $R_3$ den dritten Widerstand, $U_{Ref}$ die Referenzspannung und $U_{BE}$ die Basis-Emitter-Spannung des npn-Transistors bezeichnen.

**Claims**

1. An input circuit (100) for an input unit for safe reading-in of an input signal (INO) that is applied to the input unit, comprising:

a signal input circuit (110) having a single-channel peripheral port for connecting at least one signal generator for providing the input signal (INO);

an analyzing circuit (120) which can be coupled to the signal input circuit (110) via a coupling element (IC1);

a reference voltage circuit (140) electrically connected to the signal input circuit (110), for providing a reference voltage ($U_{Ref}$); and

a comparison circuit (130) coupled between the signal input circuit (110) and the coupling element (IC1), for enabling and disabling the coupling element (IC1) on the basis of the current of the input signal (INO) applied to the signal input circuit (110) and the provided reference voltage ($U_{ref}$);

wherein the comparison circuit (130) includes an npn transistor having a specific adjustable switching threshold for the current of the input signal (INO), wherein the npn transistor enables the coupling element (IC1) if the current of the input signal (INO) exceeds the switching threshold, and wherein the npn transistor disables the coupling element (IC1) if the current of the input signal (INO) is below the switching threshold; and wherein

the comparison circuit (130) includes a second resistor ($R_2$) coupled between the base of the npn transistor and a first resistor ($R_1$) of the signal input circuit (110); and wherein the comparison circuit (130) includes a third resistor ($R_3$) coupled between the emitter of the npn transistor and ground, such that the switching threshold

$$\frac{1}{R_3}(U_{Ref} - U_{BE}),$$

is equal to wherein $R_3$ denotes the third resistor, $U_{Ref}$ the reference voltage, and $U_{BE}$ the base-emitter voltage of the npn transistor.

2. The input circuit (100) according to claim 1, **characterized in that** the comparison circuit (130) is adapted to compare the provided reference voltage ($U_{Ref}$) with a voltage proportional to the current of the input signal (INO), for enabling and disabling the coupling element (IC1).

3. The input circuit (100) according to claim 1 or 2, **characterized in that** the analyzing circuit (120) provides a digital zero state for the input signal (INO) on the output side if the npn transistor disables the coupling element (IC1).

4. The input circuit (100) according to any one of the preceding claims, **characterized in that** the current through the input circuit (100) can be driven exclusively by the input signal (INO) applied to the signal input circuit (110).

5. The input circuit (100) according to any one of the preceding claims, **characterized in that** the reference voltage circuit (140) is adapted to set the switching threshold by adjusting the reference voltage.

6. The input circuit (100) according to any one of the preceding claims, **characterized in that**

the reference voltage circuit (140) includes a Zener diode.

7. The input circuit (100) according to any one of the preceding claims, **characterized in that** the coupling element (IC1) is an optocoupler.

8. The input circuit (100) according to any one of the preceding claims, **characterized in that** a first test circuit (150) electrically connected to the signal input circuit (110) is provided for testing the comparison circuit (130) and the coupling element (IC1).

9. The input circuit (100) according to any one of the preceding claims, **characterized in that** a limiting unit (160) for limiting the current of the input signal (INO) is arranged between the signal input circuit (110) and the comparison circuit (130).

10. The input circuit (100) according to any one of the preceding claims, **characterized in that** a second test circuit (170) electrically connected to the reference voltage circuit (140) is provided for testing the reference voltage ($U_{Ref}$) provided by the reference voltage circuit (140).

11. An input unit (500), comprising:

    at least one input circuit (100, 101, 102) according to any one of the preceding claims, for safe reading-in of an input signal that is applied to the input unit.

12. The input unit (500) according to claim 11, **characterized by** comprising a plurality of input circuits (100, 101, 102) according to any one of claims 1 to 11, a single reference voltage circuit (140) for providing a reference voltage ($U_{Ref}$), and a single second test circuit (170) for testing the reference voltage circuit (140).

13. A method of operating an input circuit (100) for an input unit for safe reading-in of an input signal (INO) that is applied to the input unit, wherein the input circuit (100) comprises a signal input circuit (110) having a single-channel peripheral port for connecting at least one signal generator for providing the input signal (INO), and comprises an analyzing circuit (120) which can be coupled to the signal input circuit (110) via a coupling element (IC1); and wherein the input circuit (100) comprises a comparison circuit (130) including an npn transistor that has a specific adjustable switching threshold for the current of the input signal (INO), including a second resistor ($R_2$) coupled between the base of the npn transistor and a first resistor ($R_1$) of the signal input circuit (110), and including a third resistor ($R_3$) coupled between the emitter of the npn transistor and ground; comprising the steps of:

    providing (601) a reference voltage ($U_{Ref}$) in a reference voltage circuit (140) that is electrically connected to the signal input circuit (110); and enabling and disabling (602) the coupling element (IC1) on the basis of the current of the input signal (INO) applied to the signal input circuit (110) and of the provided reference voltage ($U_{Ref}$), such that the switching threshold be-

$$\frac{1}{R_3}\left(U_{Ref}-U_{BE}\right)$$

comes equal to and the npn transistor enables the coupling element (IC1) if the current of the input signal (INO) exceeds the switching threshold, and the npn transistor disables the coupling element (IC1) if the current of the input signal (INO) is below the switching threshold, wherein $R_3$ denotes the third resistor, $U_{Ref}$ the reference voltage, and $U_{BE}$ the base-emitter voltage of the npn transistor.

**Revendications**

1. Circuit d'entrée (100) destiné à un module d'entrée pour la lecture fiable d'un signal d'entrée (INO) s'appliquant contre le module d'entrée, comprenant :

    un circuit d'entrée de signal (110) comprenant un raccord périphérique à un canal pour le raccordement d'au moins un générateur de signaux destiné à fournir le signal d'entrée (INO), un circuit d'évaluation (120) pouvant être couplé au circuit d'entrée de signal (110) par un élément de couplage (IC1), un circuit de tension de référence (140) relié électriquement au circuit d'entrée de signal (110) et destiné à fournir une tension de référence ($U_{Ref}$) et un circuit de comparaison (130) couplé entre le circuit d'entrée de signal (110) et l'élément de couplage (IC1) pour l'activation et la désactivation de l'élément de couplage (IC1) en fonction du courant du signal d'entrée (INO) s'appliquant contre le circuit d'entrée de signal (110) et de la tension de référence ($U_{Ref}$), le circuit de comparaison (130) comprenant un transistor npn à seuil de commutation réglable déterminé pour le courant du signal d'entrée (INO), le transistor npn activant l'élément de couplage (IC1) au cas où le courant du signal d'entrée (INO) serait supérieur au seuil de commutation et le transistor npn désactivant l'élément de couplage (IC1) au cas où le courant du signal d'entrée (INO) serait inférieur au seuil de commutation et

le circuit de comparaison (130) comprenant une deuxième résistance ($R_2$) couplée entre la base du transistor npn et une première résistance ($R_1$) du circuit d'entrée de signal (110), et le circuit de comparaison (130) comprend une troisième résistance ($R_3$) couplée entre l'émetteur du transistor npn et la masse,

de sorte que le seuil de commutation est égal à

$$\frac{1}{R_3}\left(U_{Ref} - U_{BE}\right)$$

, $R_3$ désignant la troisième résistance, $U_{Ref}$ la tension de référence et $U_{BE}$ la tension d'émetteur de base du transistor npn.

2. Circuit d'entrée (100) selon la revendication 1, **caractérisé en ce que** le circuit de comparaison (130) est conçu pour comparer la tension de référence ($U_{Ref}$) fournie à une tension proportionnelle au courant du signal d'entrée (INO) pour l'activation et la désactivation de l'élément de couplage (IC1).

3. Circuit d'entrée (100) selon la revendication 1 ou 2, **caractérisé en ce que** le circuit d'évaluation (120) fournit côté sortie un état zéro numérique pour le signal d'entrée (INO) au cas où le transistor npn désactiverait l'élément de couplage (IC1).

4. Circuit d'entrée (100) selon l'une quelconque des revendications précédentes, **caractérisé en ce que** le courant traversant le circuit d'entrée (100) peut être commandé exclusivement par le signal d'entrée (INO) s'appliquant contre le circuit d'entrée de signal (110).

5. Circuit d'entrée (100) selon l'une quelconque des revendications précédentes, **caractérisé en ce que** le circuit de tension de référence (140) est conçu pour régler le seuil de commutation par réglage de la tension de référence.

6. Circuit d'entrée (100) selon l'une quelconque des revendications précédentes, **caractérisé en ce que** le circuit de tension de référence (140) comprend une diode Zener.

7. Circuit d'entrée (100) selon l'une quelconque des revendications précédentes, **caractérisé en ce que** l'élément de couplage (IC1) est un optocoupleur.

8. Circuit d'entrée (100) selon l'une quelconque des revendications précédentes, **caractérisé en ce qu'**un premier circuit d'essai (150) relié électriquement au circuit d'entrée de signal (110) est destiné à tester le circuit de comparaison (130) et l'élément de couplage (IC1).

9. Circuit d'entrée (100) selon l'une quelconque des revendications précédentes, **caractérisé en ce qu'**une unité de limitation (160) destinée à limiter le courant du signal d'entrée (INO) est agencée entre le circuit d'entrée de signal (110) et le circuit de comparaison (130).

10. Circuit d'entrée (100) selon l'une quelconque des revendications précédentes, **caractérisé en ce qu'**un deuxième circuit d'essai (170) relié électriquement au circuit de tension de référence (140) et destiné à tester la tension de référence ($U_{Ref}$) fournie par le circuit de tension de référence (140) est prévu.

11. Module d'entrée (500), comprenant :

   au moins un circuit d'entrée (100, 101, 102) pour la lecture fiable d'un signal d'entrée s'appliquant contre le module d'entrée selon l'une quelconque des revendications précédentes.

12. Module d'entrée (500) selon la revendication 11, **caractérisé en ce qu'**une pluralité de circuits d'entrée (100, 101, 102) selon l'une des revendications 1 à 11, un seul circuit de tension de référence (140) destiné à fournir une tension de référence ($U_{Ref}$) et un seul deuxième circuit d'essai (170) destiné à tester le circuit de tension de référence (140) sont prévus.

13. Procédé permettant de faire fonctionner un circuit d'entrée (100) destiné à un module d'entrée pour la lecture fiable d'un signal d'entrée (INO) s'appliquant contre le module d'entrée, le circuit d'entrée (100) comprenant un circuit d'entrée de signal (110) comprenant un raccord périphérique à un canal pour le raccordement d'au moins un générateur de signaux destiné à fournir le signal d'entrée (INO) et un circuit d'évaluation (120) pouvant être couplé au circuit d'entrée de signal (110) par un élément de couplage (IC1),

et le circuit d'entrée (100) comprenant un circuit de comparaison (130) pourvu d'un transistor npn à seuil de commutation réglable déterminé pour le courant du signal d'entrée (INO), une deuxième résistance ($R_2$) couplée entre la base du transistor npn et une première résistance ($R_1$) du circuit d'entrée de signal (110) et une troisième résistance ($R_3$) couplée entre l'émetteur du transistor npn et la masse,

comprenant les étapes consistant à :

   fournir (601) une tension de référence ($U_{Ref}$) dans un circuit de tension de référence (140) qui est relié électriquement au circuit d'entrée de signal (110), et

   activer et désactiver (602) l'élément de couplage (IC1) en fonction du courant du signal d'entrée (INO) s'appliquant contre le circuit d'entrée de signal (110) et de la tension de référence

($U_{Ref}$) fournie, de sorte que le seuil de commutation est égal à $\dfrac{1}{R_3(U_{Ref} - U_{BE})}$ et que le transistor npn active l'élément de couplage (IC1) au cas où le courant du signal d'entrée (INO) serait supérieur au seuil de commutation, et que le transistor npn désactive l'élément de couplage (IC1) au cas où le courant du signal d'entrée (INO) serait inférieur au seuil de commutation, $R_3$ désignant la troisième résistance, $U_{Ref}$ la tension de référence et $U_{BE}$ la tension d'émetteur de base du transistor npn.

Fig. 1

EP 2 506 436 B1

Fig. 2

EP 2 506 436 B1

Fig. 3

EP 2 506 436 B1

Fig. 4

EP 2 506 436 B1

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102006030114 A1
- EP 0393282 A2
- DE 19906932 A1
- GB 2241126 A
- US 4788458 A